# EUROPEAN PATENT SPECIFICATION

(11) **EP 3 238 228 B1**
(45) Date of publication and mention of the grant of the patent: **31.07.2019**
(21) Application number: 14908668.8
(22) Date of filing: 22.12.2014
(51) Int. Cl.: H01L 31/18

(54) **METHOD FOR PRODUCING A LAYER SYSTEM FOR THIN-FILM SOLAR CELLS HAVING A SODIUM INDIUM SULFIDE BUFFER LAYER**
VERFAHREN ZUR HERSTELLUNG EINES SCHICHTSYSTEMS FÜR DÜNNSCHICHT-SOLARZELLEN MIT EINER NATRIUM-INDIUM-SULFIDPUFFERSCHICHT
PROCÉDÉ DE FABRICATION D'UN SYSTÈME DE COUCHES DESTINÉ À DES CELLULES SOLAIRES EN COUCHES MINCES AYANT UNE COUCHE TAMPON DE SULFURE D'INDIUM ET DE SODIUM

(43) Date of publication of application: 01.11.2017
(73) Proprietor: Bengbu Design & Research Institute for Glass Industry, Bengbu, Anhui 233010 (CN)
(72) Inventor: PALM, Jorg, 80797 München (DE); POHLNER, Stephan, 81541 München (DE); HAPP, Thomas, 81825 München (DE); DALIBOR, Thomas, 82211 Herrsching am Ammersee (DE); JOST, Stefan, 81543 München (DE); DIETMUELLER, Roland, 80636 München (DE); VERMA, Rajneesh, 82008 München (DE)
(74) Representative: Gebauer, Dieter Edmund
(86) International application number: PCT/CN2014/094506
(87) International publication number: WO 2016/101097

(56) References cited:
- WO-A1-2013/189968
- WO-A1-2014/207226
- CN-A- 103 227 243
- N. BARREAU ET AL.: 'A study of bulk NaxCu1_xIn5S8 and its impact on the Cu(In , Ga)Se2/In2S3 interface of solar cells' SOLAR ENERGY MATERIALS & SOLAR CELLS vol. 90, no. 12, 18 January 2006, pages 1840 - 1848, XP028002140
- N.BARREAU ET AL.: 'New Cd-free buffer layer deposited by PVD: In2S3 containing Na compounds' THIN SOLID FILMS vol. 431-432, 01 May 2003, pages 326 - 329, XP004428660

## Description

The present invention is in the technical area of the manufacture of solar cells and relates to a method for producing a layer system for thin-film solar cells with a sodium indium sulfide buffer layer.

Photovoltaic layer systems for solar cells for the direct conversion of sunlight into electrical energy are well known. The term "thin-film solar cells" refers to layer systems with thicknesses of only a few microns that require (carrier) substrates for adequate mechanical stability. Known substrates include inorganic glass, plastics (polymers), or metals, in particular, metal alloys, and can, depending on the respective layer thickness and the specific material properties, be designed as rigid plates or flexible films.

Layer systems for thin-film solar cells are available on the market in various designs, depending on the substrate and materials applied thereon. The materials are selected such that the incident solar spectrum is utilized to the maximum. Due to the physical properties and the technical handling qualities, layer systems with amorphous, micromorphous, or polycrystalline silicon, cadmium telluride (CdTe), gallium arsenide (GaAs), copper indium (gallium) selenide sulfide (Cu(In,Ga)(S,Se)₂), and copper zinc tin sulfoselenide (CZTS from the group of the kesterites) as well as organic semiconductors are particularly suited for thin-film solar cells. The pentenary semiconductor Cu(In,Ga)(S,Se)₂ belongs to the group of chalcopyrite semiconductors that are frequently referred to as CIS (copper indium diselenide or copper indium disulfide) or CIGS (copper indium gallium diselenide, copper indium gallium disulfide, or copper indium gallium disulfoselenide). In the abbreviation CIGS, S can represent selenium, sulfur, or a mixture of the two chalcogens.

Current thin-film solar cells and solar modules based on Cu(In,Ga)(S,Se)₂ require a buffer layer between a p-conductive Cu(In,Ga)(S,Se)₂ absorber layer and an n-conductive front electrode. The front electrode usually includes zinc oxide (ZnO). According to current knowledge, this buffer layer enables electronic adaptation between the absorber material and the front electrode. Moreover, it offers protection against sputtering damage in the subsequent process step of deposition of the front electrode by DC-magnetron sputtering. Additionally, by constructing a high-ohm intermediate layer between p- and n-semiconductors, it prevents current drain from electronically good conductive zones into poor conductive zones. To date, cadmium sulfide (CdS) has been most frequently used as a buffer layer. To be able to produce good efficiency of the cells, cadmium sulfide has been wet-chemically deposited in a chemical bath process (CBD process). However, associated with this is the disadvantage that the wet-chemical process does not fit well into the process cycle of current production of Cu(In,Ga)(S,Se)₂ thin-film solar cells. Another disadvantage of the CdS buffer layer consists in that it includes the toxic heavy metal cadmium. This creates higher production costs since increased safety precautions must be taken in the production process, for example, in the disposal of the wastewater. The disposal of the product can cause higher costs for the customer since, depending on the local laws, the manufacturer can be forced to take back, to dispose of, or to recycle the product.

Consequently, various alternatives to the buffer made of cadmium sulfide have been tested for different absorbers from the family of the Cu(In,Ga)(S,Se)₂ semiconductors, for example, sputtered ZnMgO, Zn(S,OH) deposited by CBD, In(O,OH) deposited by CBD, and indium sulfide deposited by atomic layer deposition (ALD), ion layer gas deposition (ILGAR), spray pyrolysis, or physical vapor deposition (PVD) processes, such as thermal evaporation or sputtering. However, these materials are still not suitable for commercial use as a buffer for solar cells based on Cu(In,Ga)(S,Se)₂, since they do not achieve the same efficiencies as those with a CdS buffer layer. The efficiency describes the ratio of incident power to the electrical power produced by a solar cell and is as much as roughly 20% for CdS buffer layers for lab cells on small surfaces and between 10% and 15% for large-area modules. Moreover, alternative buffer layers present excessive instabilities, hysteresis effects, or degradations in efficiency when they are exposed to light, heat, and/or moisture.

Another disadvantage of CdS buffer layers resides in the fact that cadmium sulfide is a semiconductor with a direct electronic bandgap of roughly 2.4 eV. Consequently, in a Cu(In,Ga) (S,Se)₂/CdS/ZnO solar cell, already with CdS film thicknesses of a few 10 nm, the incident light is, to a large extent, absorbed. The light absorbed in the buffer layer is lost for the electrical yield since the charge carriers generated in this layer recombine right away and there are many crystal defects in this region of the heterojunction and in the buffer material acting as recombination centers. As a result, the efficiency of the solar cell is reduced, which is disadvantageous for a thin-film solar cell.

A layer system with a buffer layer based on indium sulfide is known, for example, from WO 2009/141132 A2. The layer system consists of a chalcopyrite absorber of the CIGS family and, in particular, consists of Cu(In,Ga)(S,Se)₂ in conjunction with a buffer layer made of indium sulfide. The indium sulfide (InᵥS_{w}) buffer layer has, for example, a slightly indium-rich composition with v/(v+w)=41% to 43%. The indium sulfide buffer layer can be deposited with various non-wet chemical methods, for example, by thermal evaporation, electron beam evaporation, ion layer gas reaction (ILGAR), cathodic sputtering (sputtering), atomic layer deposition (ALD), or spray pyrolysis.

In the development to date of these layer systems and the production methods, it has, however, been demonstrated that the efficiency of solar cells with an indium sulfide buffer layer is less than that with CdS buffer layers.
A process for manufacturing a sodium indium sulfide buffer layer on a CIGs- based absorber layer is known from Barreau et al: "New Cd-free buffer layer deposited by PVD: In2S3 containing Na compounds",THIN SOLID FILMS, vol. 431-432, 1 May 2003 (2003-05-01), pp. 326-329. In this publication, the buffer layer contains sodium indium sulfide according to the formula In_{21.33-x}NaₓS₃₂ with 0 ≤ x ≤ 0.8. The buffer layer is formed by evaporation of thin layers of indium and sodium fluoride sequentially deposited on the substrate, followed by a sulfurization of the blend of indium and sodium fluoride.

A buffer layer based on sodium-alloyed indium sulfide is known from Barreau et al.: "Study of the new β-In2S3 containing Na thin films. Part II: Optical and electrical characterization of thin films", Journal of Crystal Growth, 241 (2002), pp. 51-56.

As results from Fig. 5 of this publication, by means of an increase in the sodium fraction from 0 atom-% to 6 atom-% in the buffer layer, the bandgap increases to values up to 2.95 eV. Since, however, the buffer layer has, among other things, the task of band adaptation of the absorber layer to the front electrode, such a high bandgap in interaction with typical absorber materials results in a degradation of the electrical properties of the solar cells.

Further background art can be taken from WO 2013/189968 A1 which discloses a buffer layer containing sodium indium sulfide chloride according to the formula NaₓIn₁S_{y}Cl_{z} with 0.05≤x<0.2 or 0.2≤x≤0.5, 1≤y<2, and 0.6≤x/z<1.4.

In contrast, the object of the present invention consists in providing a layer system for thin-film solar cells with an absorber layer, based on a chalcopyrite compound semiconductor, and a buffer layer that has high efficiency and high stability, production of which should be economical and environmentally safe. This and other objects are accomplished by a method for producing a layer system with the characteristics of the independent claims. Advantageous embodiments of the invention are indicated through the characteristics of the subclaims.

The method according to the invention for producing a layer system for thin-film solar cells includes the production of an absorber layer for absorbing light. The absorber layer contains a chalcopyrite compound semiconductor, in particular Cu₂ZnSn(S,Se)₄, Cu(In,Ga,Al)(S,Se)₂, CuInSe₂, CuInS₂, Cu(In,Ga)Se₂, or Cu(In,Ga)(S,Se)₂. In an advantageous embodiment of the absorber layer, it is made of such a chalcopyrite compound semiconductor.

Expediently, the absorber layer is applied on a substrate on the rear electrode in an RTP ("rapid thermal processing") process. For Cu(In,Ga)(S,Se)₂ absorber layers, a precursor layer is first deposited on the substrate with a rear electrode. The precursor layer contains the elements copper, indium, and gallium, which are applied by sputtering. At the time of the coating by the precursor layer, a targeted sodium dose is introduced into the precursor layer, as is known, for example, from EP 715 358 B1. Moreover, the precursor layer contains elemental selenium, which is applied by thermal evaporation. During these processes, the substrate temperature is below 100°C such that the elements remain substantially unreacted as a metal alloy and elemental selenium. Subsequently, this precursor layer is reacted in a rapid thermal processing method (RTP) in a sulfur-containing atmosphere to form a Cu(In,Ga)(S,Se)₂ chalcogenide semiconductor.

The method according to the invention for producing a layer system further includes the production of a buffer layer arranged on the absorber layer, which buffer layer contains sodium indium sulfide according to the molecular formula NaₓIn_{y-x/3}S with 0.063 ≤ x ≤ 0.625 and 0.681 ≤ y ≤ 1.50. The molecular formula NaₓIn_{y-x/3}S describes the mole fractions of sodium, indium, and sulfur in the buffer layer, based on sodium indium sulfide, where the index x indicates the substance amount of sodium and for the substance amount of indium, the index x and another index y is definitive, with the substance amount of indium determined from the value of y-x/3. For the substance amount of sulfur, the index is always 1. In order to obtain the mole fraction of a substance in atom-%, the index of the substance is divided by the sum of all indices of the molecular formula. If, for example, x = 1 and y = 1.33, this yields the molecular formula NaInS, where sodium, indium, and sulfur, based on sodium indium sulfide, each have a mole fraction of ca. 33 atom-%.

As used here and in the following, the mole fraction of a substance (element) of sodium indium sulfide describes in atom-% the fraction of the substance amount of this substance (element) in sodium indium sulfide based on the sum of the substance amounts of all substances (elements) of the molecular formula. The mole fraction of a substance based on sodium indium sulfide corresponds to the mole fraction of the substance in the buffer layer, if no elements different from sodium, indium, and sulfur are present in the buffer layer or these elements have a negligible fraction.

The buffer layer is composed of (or made of) sodium indium sulfide according to the molecular formula NaₓIn_{y-x/3}S with 0.063 ≤ x ≤ 0.625 and 0.681 ≤ y ≤ 1.50 and one or a plurality of components (impurities) different from sodium indium sulfide. In an advantageous embodiment of the invention, the buffer layer consists substantially of sodium indium sulfide according to the molecular formula NaₓIn_{y-x/3}S with 0.063 ≤ x ≤ 0.625 and 0.681 ≤ y ≤ 1.50. This means that the components (impurities) of the buffer layer different from sodium indium sulfide have a negligible fraction. It is, however, possible that the components (impurities) of the buffer layer different from sodium indium sulfide have a non-negligible fraction. If not based on the elements of the molecular form of a sodium indium sulfide, the mole fraction of a substance (impurity) in atom-% describes the fraction of the substance amount of this substance based on the sum of the substance amounts of all substances in the buffer layer (i.e., based on sodium indium sulfide and impurities).

According to the invention, in the above-mentioned step b) for producing the buffer layer, the buffer layer is produced based on at least one sodium thioindate compound. At least one sodium thioindate compound is used as a starting material (source) for producing the buffer layer. Here and in the following, the term "sodium thioindate compound" means a ternary chemical compound, which is composed of the elements sodium (Na), indium (In), and sulfur (S). The elements can be present in the sodium thioindate compound in each case in different oxidation states.

It is essential that the production of the buffer layer take place without deposition of indium sulfide, in contrast to the method that is presented in the unpublished international patent application PCT/EP2014/063747. In particular, no separate deposition of indium sulfide occurs for the production of the buffer layer. Thus, neither indium sulfide nor indium and sulfur is used as a starting material (source) for the deposition of indium sulfide. Here and in the following, the term "indium sulfide" means a binary chemical compound, which is composed of the elements indium (In) and sulfur (S), for example, InS, In₂S₃ and In₆S₇. The elements can be present in the indium sulfide in each case in different oxidation states.

For example, but not mandatorily, the buffer layer is produced only on the basis of at least one sodium thioindate compound, i.e., none of the substances different from the at least one sodium thioindate compound is used for producing the buffer layer.
Preferably, the buffer layer is produced on the basis of one or plurality of sodium thioindate compounds, selected from NaIn₃S₅, NaIn₅S₈, and NaInS₂. Conceivably, other sodium thioindate compounds could also be used, such as NaIn₅S₇ or Na₆In₂S₆.

The formulation, according to which the buffer layer is produced "on the basis of at least one sodium thioindate compound", includes both the case that the stoichiometry of the buffer layer with regard to the components sodium, indium, and sulfur corresponds to the stoichiometry of these components in the at least one sodium thioindate compound used as starting material, and also the case that the stoichiometry of the buffer layer with regard to the components sodium, indium, and sulfur does not correspond to the stoichiometry of these components in the at least one sodium thioindate compound used as starting material.

The use of at least one ternary sodium thioindate compound for producing the buffer layer brings with it substantial process-technology advantages compared to other methods. One important advantage is the simple handling quality of the ternary sodium thioindate compounds with regard to hygroscopy, toxicity, and flammability, compared to a production method in which indium sulfide is deposited. In addition, the production of the buffer layer is possible with a relatively small number of starting materials (in the simplest case, only a single sodium thioindate compound), by which means the complexity of the production process and thus the costs of producing the layer system can be significantly reduced.

According to an advantageous embodiment of the method according to the invention, the buffer layer is produced by depositing a single sodium thioindate compound or by depositing a plurality of sodium thioindate compounds different from each other onto the absorber layer. In this case, the stoichiometry of the buffer layer with regard to the components sodium, indium, and sulfur corresponds to stoichiometry of these components in the at least one sodium thioindate compound used as starting material.

In principle, all chemical-physical deposition methods are suitable for producing the buffer layer. Advantageously, the buffer layer according to the invention is applied on the absorber layer by wet-chemical bath deposition, atomic layer deposition (ALD), ion layer gas deposition (ILGAR), spray pyrolysis, chemical vapor deposition (CVD), or physical vapor deposition (PVD). The buffer layer according to the invention is preferably deposited by sputtering (cathodic sputtering), thermal evaporation, or electron beam evaporation, in particular from separate sources for at least one or various sodium thioindate compounds.

The buffer layer according to the invention is advantageously deposited with a vacuum method. The vacuum method has the particular advantage that in the vacuum, the incorporation of oxygen or hydroxide is prevented. Hydroxide components in the buffer layer are believed to be responsible for transients in efficiency under the effect of heat and light. Moreover, vacuum methods have the advantage that the method does without wet chemistry and standard vacuum coating equipment can be used.

According to another advantageous embodiment of the method according to the invention, in step b), the buffer layer is deposited out of the gas phase onto the absorber layer, wherein the concentration of at least one component of the material to be deposited is reduced in its gas phase, and thus, before its deposition on the absorber layer, compared to the concentration of this component in the starting material (sodium thioindate compound). Thus, for example, the concentration of the component sulfur can be reduced in its gas phase compared to the concentration in the starting material (sodium thioindate compound). In this case, the stoichiometry of the buffer layer with regard to the components sodium, indium, and sulfur no longer corresponds to stoichiometry of these components in the at least one sodium thioindate compound used as starting material. The concentration of a component can be reduced in the gas phase, for example, by an element introduced into a deposition chamber for deposition of the buffer layer, commonly referred to as a "getter element", onto which the component bonds physically and/or chemically. The various measures for reducing the concentration of a component in its gas phase are well-known per se to the person skilled in the art, for example, from the international patent application WO 2011/104235, such that this need not be dealt with in detail here. By this means, it is advantageously possible to selectively influence the stoichiometry of the components sodium, indium, and sulfur in the buffer layer in particular to further improve the efficiency of the solar cells.

In an advantageous embodiment of the method according to the invention, the absorber layer is conveyed, in an in-line method or in a rotation method, past a steam beam of a sodium thioindate compound or past a plurality of steam beams of sodium thioindate compounds different from each other with completely, partially, or not overlapping steam beams. In the context of the present invention, "steam beam" means the region in front of the outlet of the source that is technically suitable for the deposition of the evaporated material on a substrate in terms of deposition rate and homogeneity. The source is, for example, an effusion cell, a boat or crucible of a thermal evaporator, a resistance heater, an electron beam evaporator, or a linear evaporator.

The buffer layer is produced such that the percentage fraction (atom-%) of sodium indium sulfide according to the molecular formula NaₓIn_{y-x/3}S with 0.063 ≤ x ≤ 0.625 and 0.681 ≤ y ≤ 1.50 (i.e., the sum of the respective percentage fractions (atom-%) of the elements of sodium indium sulfide) in the buffer layer is at least 75%, preferably at least 80%, more preferably at least 85%, even more preferably at least 90%, even more preferably at least 95%, and most preferably at least 99%. The buffer layer thus consists of at least 75% sodium indium sulfide and a maximum of 25% of components different from sodium indium sulfide, preferably of at least 80% sodium indium sulfide and a maximum of 20% of components different from sodium indium sulfide, more preferably of at least 85% sodium indium sulfide and a maximum of 15% components different from sodium indium sulfide, even more preferably of at least 90% sodium indium sulfide and a maximum of 10% of components different from sodium indium sulfide, even more preferably of at least 95% sodium indium sulfide and a maximum of 5% of components different from sodium indium sulfide, and most preferably of at least 99% sodium indium sulfide and a maximum of 1% of components different from sodium indium sulfide (all data in atom-%).

Since the elements of the buffer layer can, in each case, be present in different oxidation states, all oxidation states are referred to uniformly in the following with the name of the element unless explicitly indicated otherwise. For example, the term "sodium" means elemental sodium and sodium ions as well as sodium in compounds.

Due to alloying with sodium, the sodium indium sulfide buffer layer of the layer systems according to the invention advantageously has an amorphous or fine crystalline structure. The mean particle size is limited by the thickness of the buffer layer and is advantageously in the range from 8 nm to 100 nm and more preferably in the range from 20 nm to 60 nm, for example, 30 nm.

As investigations have shown, the inward diffusion of copper (Cu) from the absorber layer into the buffer layer can be inhibited by the amorphous or fine crystalline structure of the buffer layer. This can be explained by the fact that sodium and copper take the same sites in the indium sulfide lattice and the sites are occupied by sodium. The inward diffusion of large quantities of copper is, however, disadvantageous, since the bandgap of the buffer layer is reduced by copper. This results in an increased absorption of light in the buffer layer and thus in a reduction of efficiency. By means of a mole fraction of copper in the buffer layer of less than 7 atom-%, in particular less than 5 atom-%, particularly high efficiency of the solar cell can be ensured.

In an advantageous embodiment of the method according to the invention, the buffer layer is produced such that sodium indium sulfide according to the molecular formula NaₓIn_{y-x/3}S with 0.063 ≤ x ≤ 0.469 and 0.681 ≤ y ≤ 1.01 is contained in the buffer layer. It was possible to measure particularly high efficiencies for these values. The best efficiencies to date were measured for a buffer layer in which sodium indium sulfide according to the molecular formula NaₓIn_{y-x/3}S with 0.13 ≤ x ≤ 0.32, and 0.681 ≤ y ≤ 0.78 is contained.

In another advantageous embodiment of the method according to the invention, the buffer layer is produced such that the buffer layer has a mole fraction of sodium of more than 5 atom-%, in particular more than 7 atom-%, in particular more than 7.2 atom-%. It was possible to measure particularly high efficiencies for such a high sodium fraction. The same is true for a buffer layer in which the ratio of the mole fractions of sodium and indium is greater than 0.2.

In another advantageous embodiment of the method according to the invention, the buffer layer is produced such that it contains a mole fraction of a halogen, in particular chlorine, of less than 7 atom-%, in particular less than 5 atom-%, with it being preferable for the buffer layer to be completely halogen free. Thus, particularly high efficiency of the solar cell can be obtained. As already mentioned, it is advantageous for the buffer layer to have a mole fraction of copper of less than 7 atom-%, in particular less than 5 atom-%, with it being preferable for the buffer layer to be completely copper free.

In another advantageous embodiment of the method according to the invention, the buffer layer is produced such that the buffer layer according to the invention contains a mole fraction of oxygen of a maximum of 10 atom-%. Oxygen can, for example, be introduced via residual water vapor out of the coating equipment. By means of a mole fraction < 10 atom-% of oxygen in the buffer layer, particularly high efficiency of the solar cell can be ensured.

In another advantageous embodiment of the method according to the invention, the buffer layer is produced such that it has no substantial fraction of elements other than sodium, indium, and sulfur, Cl and O. This means that the buffer layer is not provided with other elements, such as, for example, carbon, and contains, at most, mole fractions of other elements of a maximum of 1 atom-% unavoidable from a production technology standpoint. This makes it possible to ensure high efficiency.

In another particularly advantageous embodiment of the method according to the invention, the buffer layer is produced such that the sum of the mole fractions of all impurities (i.e., of all substances, which are different from sodium indium sulfide according to the molecular formula NaₓIn_{y-x/3}S with 0.063 ≤ x ≤ 0.625 and 0.681 ≤ y ≤ 1.50) in the buffer layer is a maximum of 25 atom-%, preferably a maximum of 20 atom-%, more preferably a maximum of 15 atom-%, even more preferably a maximum of 10 atom-%, even more preferably a maximum of 5 atom-%, and most preferably a maximum of 1 atom-%.

In a typical embodiment, the buffer layer is produced such that it consists of a first layer region adjoining the absorber layer and a second layer region adjoining the first layer region, wherein the layer thickness of the first layer region is less than the layer thickness of the second layer region or equal to the layer thickness of the second layer region, and wherein the mole fraction of sodium has a maximum in the first layer region and decreases both to the absorber layer and to the second layer region.

In another advantageous embodiment of the method according to the invention, the buffer layer is produced such that it has a layer thickness from 10 nm to 100 nm and preferably from 20 nm to 60 nm.

The invention further extends to a method for producing a thin-film solar cell, which comprises:
- Preparing a substrate,
- Arranging a rear electrode on the substrate,
- Producing a layer system according to the above-described method for its production, wherein the layer system is arranged on the rear electrode, and
- Arranging a front electrode on the layer system.

The substrate is preferably a metal, glass, plastic, or ceramic substrate, glass being preferred. However, other transparent carrier materials can also be used, in particular plastics. The rear electrode advantageously includes molybdenum (Mo) or other metals. In an advantageous embodiment of the rear electrode, it has a molybdenum sublayer, which adjoins the absorber layer, and a silicon nitride sublayer (SiN), which adjoins the molybdenum sublayer. Such rear electrode systems are known, for example, from EP 1356528 A1. The front electrode preferably includes a transparent conductive oxide (TCO), particularly preferably aluminum-, gallium-, or boron-doped zinc oxide and/or indium tin oxide (ITO).

### Brief Description of the Drawings

The invention is now explained in detail using an exemplary embodiment, referring to the accompanying figures. They depict:
- Fig. 1: a schematic cross-sectional view of a thin-film solar cell produced in accordance with the method according to the invention with a layer system produced in accordance with the method according to the invention;
- Fig. 2A: a ternary diagram for the representation of the composition of the sodium indium sulfide buffer layer of the thin-film solar cell of Fig. 1;
- Fig. 2B: an enlarged detail of the ternary diagram of Fig. 2A with the region claimed according to the invention;
- Fig. 3A: a measurement of the efficiency of the thin-film solar cell of Fig. 1 as a function of the sodium indium ratio of the buffer layer;
- Fig. 3B: a measurement of the efficiency of the thin-film solar cell of Fig. 1 as a function of the absolute sodium content of the buffer layer;
- Fig. 4: a measurement of the bandgap of the buffer layer of the layer system of Fig. 1 as a function of the absolute sodium content of the buffer layer;
- Fig. 5: a measurement of the depth profile of the sodium distribution in the buffer layer of the layer system of Fig. 1 with differently high sodium fractions;
- Fig. 6: an exemplary embodiment of the process steps according to the invention using a flowchart;
- Fig. 7: a schematic representation of an in-line method according to the invention for producing the buffer layer;
- Fig. 8: a schematic representation of an alternative in-line method according to the invention for producing the buffer layer;
- Fig. 9: a schematic representation of a rotation method according to the invention for producing the buffer layer.

### Detailed Description of the Drawings

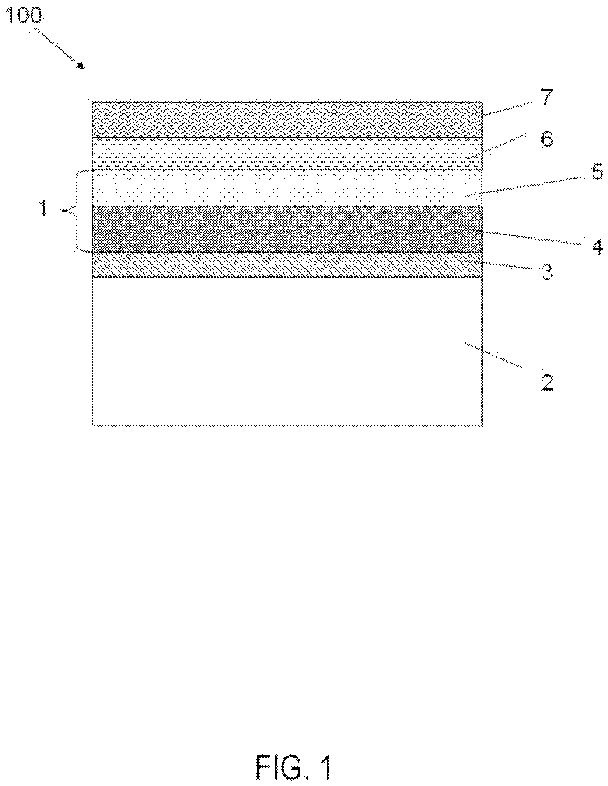

Fig. 1 depicts, purely schematically, a preferred exemplary embodiment of a thin-film solar cell 100 produced in accordance with the method according to the invention with a layer system 1 produced in accordance with the method according to the invention in a cross-sectional view. The thin-film solar cell 100 includes a substrate 2 and a rear electrode 3. A layer system 1 is arranged on the rear electrode 3. The layer system 1 includes an absorber layer 4 and a buffer layer 5. A second buffer layer 6 and a front electrode 7 are arranged on the layer system 1.

The substrate 2 is made here, for example, of inorganic glass, with it equally possible to use other insulating materials with sufficient stability as well as inert behavior relative to the process steps performed during production of the thin-film solar cell 100, for example, plastics, in particular polymers or metals, in particular metal alloys. Depending on the layer thickness and the specific material properties, the substrate 2 can be implemented as a rigid plate or flexible film. In the present exemplary embodiment, the layer thickness of the substrate 2 is, for example, from 1 mm to 5 mm.

A rear electrode 3 is arranged on the light-entry-side surface of the substrate 2. The rear electrode 3 is made, for example, from an opaque metal. It can, for example, be deposited on the substrate 2 by vapor deposition or magnetic field-assisted cathodic sputtering. The rear electrode 3 is made, for example, of molybdenum (Mo), aluminum (Al), copper (Cu), titanium (Ti), zinc (Zn), or of a multilayer system with such a metal, for example, molybdenum (Mo). The layer thickness of the rear electrode 3 is, in this case, less than 1 µm, preferably in the range from 300 nm to 600 nm, and is, for example, 500 nm. The rear electrode 3 serves as a back-side contact of the thin-film solar cell 100. An alkali barrier, made, for example, of Si₃N₄, SiON, or SiCN, can be arranged between the substrate 2 and the rear electrode 3. This is not shown in detail in Fig. 1.

A layer system 1 is arranged on the rear electrode 3. The layer system 1 includes an absorber layer 4, made, for example, of Cu(In,Ga)(S,Se)₂, which is applied directly on the rear electrode 3. The absorber layer 4 was deposited, for example, with the RTP process described in the introduction. The absorber layer 4 has, for example, a thickness of 1.5 µm.

A buffer layer 5 is arranged on the absorber layer 4. The buffer layer 5 contains NaₓIn_{y-x/3}S with 0.063 ≤ x ≤ 0.625, 0.681 ≤ y ≤ 1.50, preferably 0.063 ≤ x ≤ 0.469, 0.681 ≤ y ≤ 1,01 and even more preferably 0.13 ≤ x ≤ 0.32, 0.681 ≤ y ≤ 0.78. The layer thickness of the buffer layer 5 is in the range from 20 nm to 60 nm and is, for example, 30 nm.

A second buffer layer 6 can be arranged, optionally, above the buffer layer 5. The buffer layer 6 contains, for example, non-doped zinc oxide (i-ZnO). A front electrode 7 that serves as a front-side contact and is transparent to radiation in the visible spectral range ("window layer") is arranged above the second buffer layer 6. Usually, a doped metal oxide (TCO = transparent conductive oxide), for example, n-conductive, aluminum (Al)-doped zinc oxide (ZnO), boron (B)-doped zinc oxide (ZnO), or gallium (Ga)-doped zinc oxide (ZnO), is used for the front electrode 7. The layer thickness of the front electrode 7 is, for example, roughly 300 to 1500 nm. For protection against environmental influences, a plastic layer (encapsulation film) made, for example, of polyvinyl butyral (PVB), ethylene vinyl acetate (EVA), or silicones can be applied to the front electrode 7.

In addition, a cover plate transparent to sunlight that is made, for example, from extra white glass (front glass) with a low iron content and has a thickness of, for example, 1 to 4 mm, can be provided.

The described structure of a thin-film solar cell or of a thin-film solar module is well known to the person skilled in the art, for example, from commercially available thin-film solar cells or thin-film solar modules and has also already been described in detail in numerous printed documents in the patent literature, for example, DE 19956735 B4.

In the substrate configuration depicted in Fig. 1, the rear electrode 3 adjoins the substrate 2. It is understood that the layer system 1 can also have a superstrate configuration, in which the substrate 2 is transparent and the front electrode 7 is arranged on a surface of the substrate 2 facing away from the light-entry side.

The layer system 1 can serve for production of integrated serially connected thin-film solar cells, with the layer system 1, the rear electrode 3, and the front electrode 7 patterned in a manner known per se by various patterning lines ("P1" for rear electrode, "P2" for contact front electrode/rear electrode, and "P3" for separation of the front electrode).

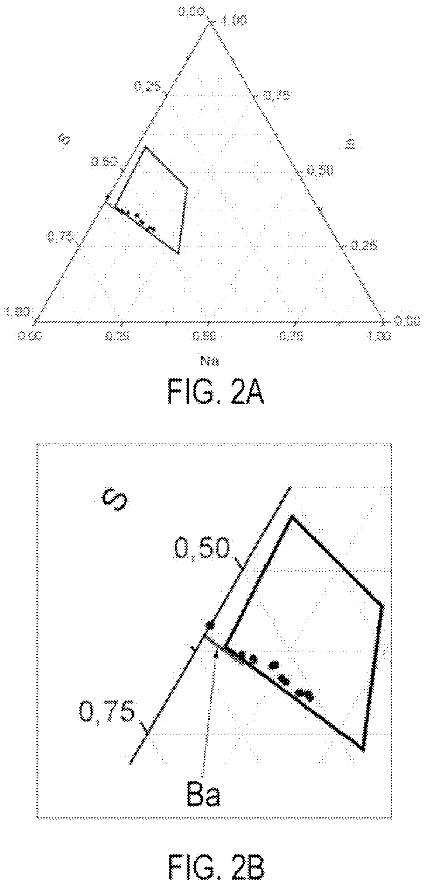

Fig. 2A depicts a ternary diagram for the representation of the composition NaₓIn_{y-x/3}S of the buffer layer 5 of the thin-film solar cell 100 of Fig. 1. The relative fractions for the components sulfur (S), indium (In), and sodium (Na) of the buffer layer 5 are indicated in the ternary diagram. The composition region claimed according to the invention, defined by 0.063 ≤ x ≤ 0.625 and
0.681 < y < 1.50, is defined by the region outlined by the solid line. Data points inside the outlined composition region indicate exemplary compositions of the buffer layer 5. Fig. 2B depicts an enlarged detail of the ternary diagram with the composition region claimed according to the invention.

The straight line identified with "Ba", which is not part of the composition region claimed by the invention, indicates a composition for a sodium indium sulfide buffer layer depicted in the publication of Barreau et al. cited in the introduction. This can be described by the molecular formula NaₓIn_{21.33-x/}S₃₂ with 1 ≤ x ≤ 4. Accordingly, the straight line is marked through the starting point In₂S₃ and the endpoint NaIn₅S₈. It is characteristic here that thin-films have a maximum sodium fraction of 5 atom-% (Na/In = 0.12) and that a monocrystal has a sodium fraction of 7 atom-% (Na/In = 0.2). High crystallinity has been reported for these layers.

As already stated in the introduction, these buffer layers have, with a sodium content of more than 6 atom-%, a bandgap of 2.95 eV, which results in an unsatisfactory band adaptation to the absorber or to the front electrode and, thus, results in the degradation of the electrical properties such that these buffer layers are unsuitable for use in thin-film solar cells. The composition range claimed according to the invention is, according to Barreau et al., impossible.

This disadvantage is avoided according to the invention in that the sodium fraction reaches values clearly higher than Na/In = 0.12 or 0.2. As the inventors were surprisingly able to demonstrate, only by means of a relatively small sulfur fraction in the buffer layer 5 is a higher sodium fraction made possible, with the satisfactory layer properties for band adaptation in the solar cells retained. For example, with the capabilities for reducing the sulfur fraction in the buffer layer described in international patent application WO 2011/104235, the composition can be selectively controlled in an indium-enriched region. Thus, it is possible to deposit the sodium indium sulfide buffer layer either amorphously or in a nanocrystalline structure (instead of crystalline), since the sodium indium sulfide phases present in the buffer layer have different crystalline structures. In this manner, an inward diffusion of copper from the absorber layer into the buffer layer can be inhibited, which improves the electrical properties of solar cells, in particular chalcopyrite solar cells. Due to alloying with sodium, the bandgap and the charge carrier concentration of the buffer layer 5 can be adjusted, by means of which the electronic transition from the absorber layer 4 via the buffer layer 5 to the front electrode 7 can be optimized. This is explained in greater detail in the following.

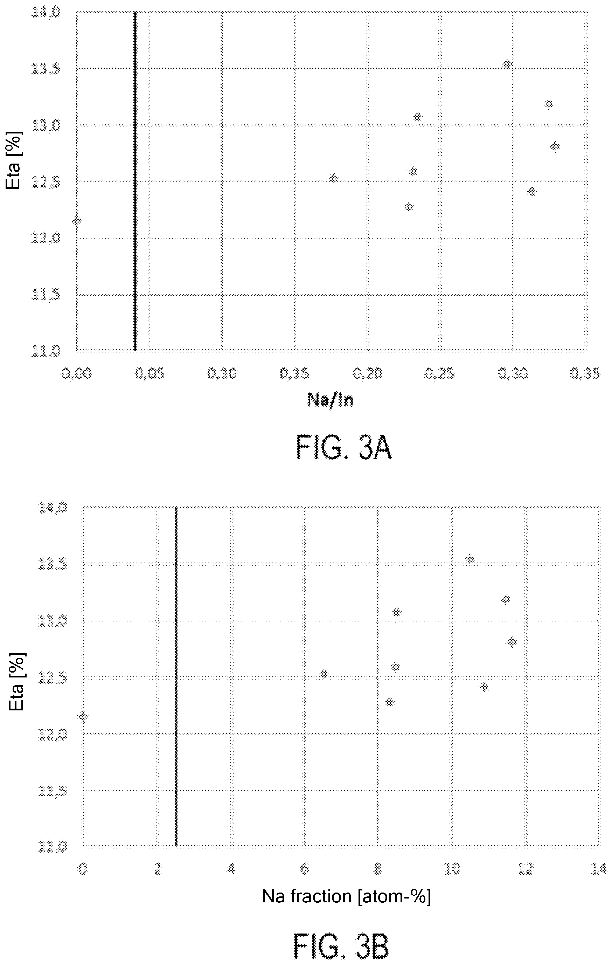

Fig. 3A depicts a diagram, in which the efficiency Eta (percent) of the thin-film solar cell 100 of Fig. 1 is plotted against the sodium indium fraction in the buffer layer 5. This is a corresponding projection from Fig. 2A. Fig. 3B depicts a diagram, in which the efficiency Eta (percent) of the thin-film solar cell 100 of Fig. 1 is plotted against the absolute sodium fraction (atom-%) in the buffer layer 5.

For example, the thin-film solar cell 100 used for this contains a substrate 2 made of glass as well as a rear electrode 3 made of a Si₃N₄ barrier layer and a molybdenum layer. An absorber layer 4 made of Cu(In,Ga) (S,Se)₂, which was deposited according to the above described RTP process, is arranged on the rear electrode 3. A NaₓIn_{y-x/3}S buffer layer 5 with 0.063 ≤ x ≤ 0.625 and 0.681 ≤ y ≤ 1.50 is arranged on the absorber layer 4. The layer thickness of the buffer layer 5 is 50 nm. A 100-nm-thick second buffer layer 6, which contains non-doped zinc oxide, is arranged on the buffer layer 5. A 1200-nm-thick front electrode 7, which contains n-conductive zinc oxide, is arranged on the second buffer layer 6. The area of the thin-film solar cell 100 is, for example, 1.4 cm².

In Fig. 3A and 3B, it is discernible that through an increase of the sodium indium fraction (Na/In > 0.2) or through an increase of the absolute sodium content (Na > 7 atom-%) of the buffer layer 5, the efficiency of the thin-film solar cell 100 can be significantly increased compared to conventional thin-film solar cells. As already stated, such a high sodium fraction can be obtained in the buffer layer 5 only through a relatively low sulfur fraction. With the structure according to the invention, it was possible to obtain high efficiencies of up to 13.5%.

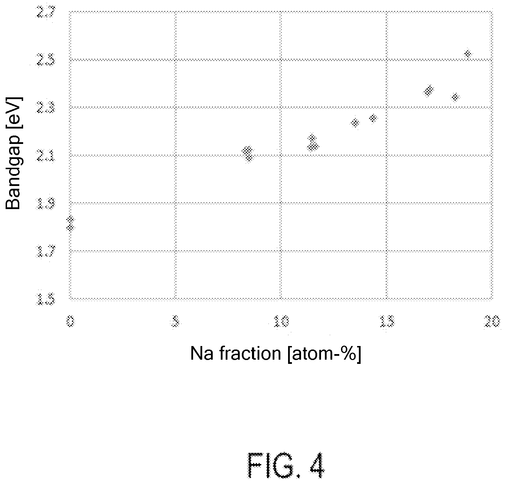

Fig. 4 depicts, for the above-described layer system 1, a measurement of the bandgap of the buffer layer 5 as a function of the sodium fraction of the buffer layer 5. Accordingly, an enlargement of the bandgap from 1.8 eV to 2.5 eV can be observed with a sodium fraction of more than 7 atom-%. By means of the buffer layer 5 according to the invention, significant improvement of the efficiency of the thin-film solar cell 100 can be obtained, without a degradation of the electrical layer properties (good band adaptation to absorber or front electrode by not excessively large bandgap).

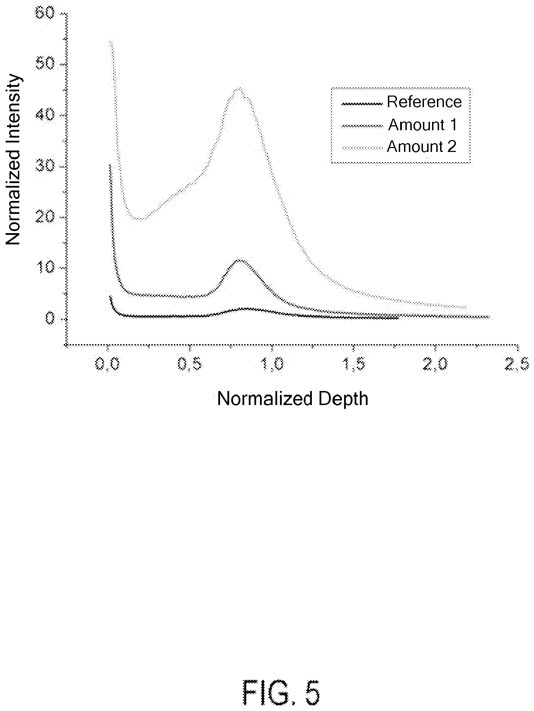

Fig. 5 depicts a depth profile of the sodium distribution in the buffer layer 5 of the layer system 1 of Fig. 1 generated by a ToF-SIMS measurement. The normalized depth is plotted as the abscissa, the normalized signal intensity is plotted as the ordinate. The region from 0 to 1 of the abscissa marks the buffer layer 5 and the region with values greater than 1 marks the absorber layer 4. Compounds of sodium with the chalcogen sulfur (S), preferably Na₂S, were used as starting materials for the sodium alloying of the indium sulfide layer. It would also be equally conceivable to use a compound of sodium with sulfur and indium, for example, NaIn₃S₅. In the buffer layer 5, which is applied in each case on a CIGSSe absorber layer 4, differently high sodium fractions are contained (amount 1, amount 2). An indium sulfide buffer layer not alloyed with sodium was used as a reference.

An increase of the sodium fraction discernibly develops in the layer stack due to the sodium alloy, with, despite uniform deposition of the alloy on the absorber-buffer interface, by means of diffusion mechanisms, a slight enrichment of the sodium fraction in the buffer layer 5 ("doping peak") developing. The buffer layer 5 can, at least theoretically, be divided into two regions, namely, a first layer region adjoining the absorber layer and a second layer region adjoining the first layer region, with the layer thickness of the first layer region being, for example, equal to the layer thickness of the second layer region. Accordingly, the mole fraction of sodium has a maximum in the first layer region and decreases both toward the absorber layer 4 and also toward the second layer region. A specific sodium concentration is retained over the entire layer thickness in the buffer layer 5. The accumulation of sodium at the absorber-buffer interface is believed to be attributable to high defect density at this location.

Besides sodium, oxygen (O) or zinc (Zn) can also accumulate in the buffer layer 5, for example, by diffusion out of the TCO of the front electrode 7. Due to the hygroscopic properties of the starting materials, an accumulation of water from the ambient air is also conceivable. Particularly advantageously, the halogen fraction in the buffer layer according to the invention is small, with the mole fraction of a halogen, for example, chlorine, being less than 5 atom-%, in particular less than 1 atom-%. Particularly advantageously, the buffer layer 5 is halogen free.

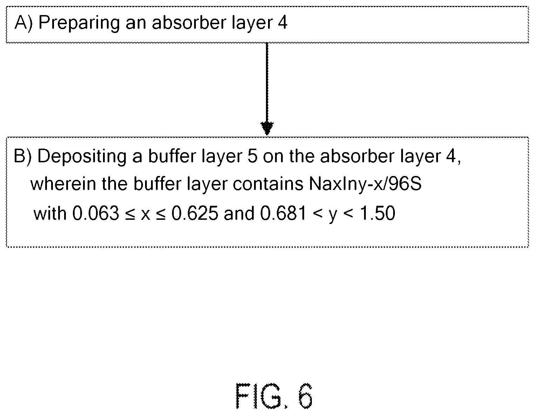

Fig. 6 depicts a flow chart of a method according to the invention. In a first step, an absorber layer 4, made, for example, of a Cu(In,Ga)(S,Se)₂ semiconductor material, is prepared. In a second step, the buffer layer 5 made of sodium indium sulfide is deposited. The ratio of the individual components in the buffer layer 5 is regulated, for example, by control of the evaporation rate, for example, by a screen or temperature control. In further process steps, a second buffer layer 6 and a front electrode 7 can be deposited on the buffer layer 5. In addition, wiring and contacting of the layer structure 1 to a thin-film solar cell 100 or a solar module can occur.

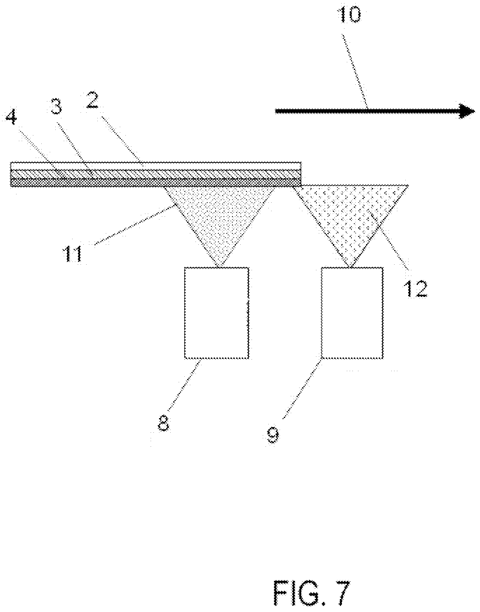

Fig. 7 depicts a schematic representation of an in-line method according to the invention for producing a buffer layer 5 made of sodium indium sulfide. The substrate 2 with rear electrode 3 and absorber layer 4 is conveyed, in an in-line method past the steam beams 11, 12 of a first sodium thioindate source 8, for example, NaIn₅S₈, as well as a second sodium thioindate source 9, for example, NaInS₂. The transport direction is indicated by an arrow with the reference character 10. The steam beams 11, 12 do not overlap. In this manner, the absorber layer 4 is coated first with a thin layer of NaIn₃S₈, then, with a thin layer of NaInS₂, which blend. Both sodium thioindate sources 8, 9 are, for example, effusion cells, from which sodium thioindate is thermally evaporated. Especially simple process control is enabled by the non-overlapping sources. It would also be conceivable for the both sources 8, 9 to contain the same sodium thioindate compound, for example, only NaIn₃S₅ or only NaIn₅S₈, or for only one single sodium thioindate source to be used, for example, the sodium thioindate source 8. Alternatively, any other form of generating steam beams 11,12 is suitable for depositing the buffer layer 5. Alternative sources are, for example, boats of linear evaporators or crucibles of electron-beam evaporators.

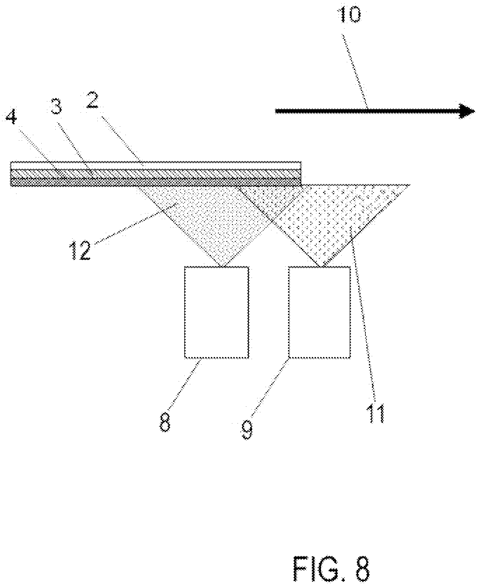

Fig. 8 depicts an alternative apparatus for performance of the method according to the invention, wherein only the differences relative to the apparatus of Fig. 7 are explained and, otherwise, reference is made to the above statements. Accordingly, the substrate 2 is conveyed, in an in-line method, past the steam beams 11,12 of two sodium thioindate sources 8, 9, wherein, in this case, the steam beams 11, 12 overlap partially. It would also be conceivable for the steam beams to overlap completely.

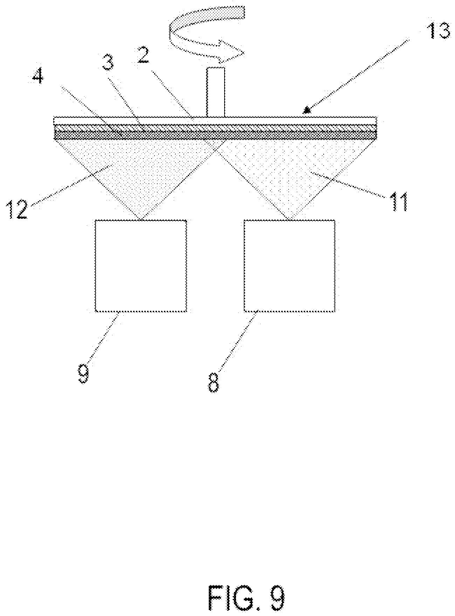

Fig. 9 depicts another alternative embodiment of the method according to the invention using the example of a rotation method. The substrate 2 with rear electrode 3 and absorber layer 4 is arranged on a rotatable sample carrier 13, for example, on a sample carousel. Alternatingly arranged sources 8, 9 of sodium thioindate, for example, a first source 8 with NaIn₅S₈ and a second source 9 with NaInS₂ are situated below the sample carrier 13.
During the deposition of the buffer layer 5, the sample carrier 13 is rotated. Thus, the substrate 2 is moved into the steam beams 11, 12 and coated.

From the above assertions, it has become clear that by means of the present invention, the disadvantages of previously used CdS buffer layers could be overcome in thin-film solar cells, with the efficiency and the stability of the solar cells produced therewith also very good or better. At the same time, the production method is, through the use of at least one sodium thioindate compound technically relatively simple, economical, effective, and environmentally safe. It has been demonstrated that with the layer system according to the invention, comparably good solar cell characteristics can be obtained as are present with conventional CdS buffer layers.

### List of Reference Characters

- 1: layer system
- 2: substrate
- 3: rear electrode
- 4: absorber layer
- 5: buffer layer
- 6: second buffer layer
- 7: front electrode
- 8: first sodium thioindate source
- 9: second sodium thioindate source
- 10: transport direction
- 11: first steam beam
- 12: second steam beam
- 13: sample carrier
- 100: thin-film solar cell

## Claims

1. Method for producing a layer system (1) for thin-film solar cells (100), wherein
a) an absorber layer (4) is produced, wherein the absorber layer (4) contains a chalcopyrite compound semiconductor, and
b) a buffer layer (5) is produced on the absorber layer (4), wherein the buffer layer (5) contains sodium indium sulfide according to the formula NaₓIn_{y-x/3}S with 0.063 ≤ x ≤ 0.625 and 0.681 ≤ y ≤ 1.50, wherein the atomic percentage fraction of sodium indium sulfide in the buffer layer is at least 75%, and wherein the buffer layer (5) is produced without deposition of indium sulfide, with at least one ternary sodium thioindate compound being used as a starting source material for producing said buffer layer.

2. Method according to claim 1, wherein the buffer layer (5) is produced based on at least one compound, selected from the sodium thioindate compounds NaIn₃S₅, NaIn₅S₈, and NaInS₂.

3. Method according to claim 1 or 2, wherein the buffer layer (5) is produced in step b) by wet-chemical bath deposition, atomic layer deposition (ALD), ion layer gas deposition (ILGAR), spray pyrolysis, chemical vapor deposition (CVD), or physical vapor deposition (PVD), sputtering, thermal evaporation, or electron beam evaporation, in particular from separate sources for at least one or various sodium thioindate compounds.

4. Method according to one of claims 1 through 3, wherein the buffer layer (5) in step b) is deposited out of the gas phase, wherein the concentration of at least one component of the material to be deposited is reduced in its gas phase and, thus, before its deposition on the absorber layer (4).

5. Method according to claim 4, wherein the concentration of the at least one component of the material to be deposited is reduced in its gas phase by bonding to a material introduced into a deposition chamber, to which the component can bond physically and/or chemically.

6. Method according to one of claims 1 through 5, wherein the absorber layer (4) is conveyed, in an in-line method or in a rotation method, past a steam beam of a sodium thioindate compound or past a plurality of steam beams (11, 12) of sodium thioindate compounds different from each other with completely, partially, or not overlapping steam beams.

7. Method according to one of claims 1 through 6, wherein the buffer layer (5) arranged on the absorber layer (4) contains sodium indium sulfide according to the formula NaₓIn_{y-x/3}S with 0.063 ≤ x ≤ 0.469 and 0.681 ≤ y ≤ 1.01.

8. Method according to one of claims 1 through 7, wherein the buffer layer (5) arranged on the absorber layer (4) contains sodium indium sulfide according to the formula NaₓIn_{y-x/3}S with 0.13 ≤ x ≤ 0.32 and 0.681 ≤ y ≤ 0.78.

9. Method according to one of claims 1 through 8, wherein in the buffer layer (5), the ratio of the mole fractions of sodium and indium is greater than 0.2.

10. Method according to one of claims 1 through 9, wherein the buffer layer (5) has a mole fraction of sodium of more than 5 atom-%, in particular more than 7 atom-%, in particular more than 7.2 atom-%.

11. Method according to one of claims 1 through 10, wherein the buffer layer (5) contains a mole fraction of a halogen, for example, chlorine, or of copper of less than 7 atom-%, in particular less than 5 atom-%.

12. Method according to one of claims 1 through 11, wherein the buffer layer (5) contains a mole fraction of oxygen of less than 10 atom-%.

13. Method according to one of claims 1 through 12, wherein the buffer layer (5) has a layer thickness from 10 nm to 100 nm, in particular from 20 nm to 60 nm, wherein the buffer layer (5) is amorphous or fine crystalline.

14. Method according to one of claims 1 through 13, wherein the chalcopyrite compound semiconductor is selected from Cu₂ZnSn(S,Se)₄, Cu(In,Ga,Al)(S,Se)₂, CuInSe₂, CuInS₂, Cu(In,Ga)Se₂, and Cu(In,Ga)(S,Se)₂.

15. Method for producing a thin-film solar cell (100), which comprises:
- Preparing a substrate (2),
- Arranging a rear electrode (3) on the substrate (2),
- Producing a layer system (1) according to one of claims 1 through 14, wherein the layer system (1) is arranged on the rear electrode (3), and
- Arranging a front electrode (7) on the layer system (1) .

## Patentansprüche

1. Verfahren zur Herstellung eines Schichtsystem (1) für Dünnschichtsolarzellen (100), wobei
a) eine Absorberschicht (4) hergestellt wird, wobei die Absorberschicht (4) einen Chalkopyritverbindungshalbleiter enthält, und
b) eine Pufferschicht (5) auf der Absorberschicht (4) hergestellt wird, wobei die Pufferschicht (5) Natriumindiumsulfid gemäß der Formel NaₓIn_{y-x/3}S mit 0,063 ≤ x ≤ 0,625 und 0,681 ≤ y ≤ 1,50 enthält, wobei der atomare prozentuale Anteil von Natriumindiumsulfid in der Pufferschicht mindestens 75% beträgt, und wobei die Pufferschicht (5), ohne Abscheidung von Indiumsulfid, mit mindestens einer ternären Natriumthioindat-Verbindung hergestellt wird, die als Ausgangsmaterial für die Herstellung dieser Pufferschicht verwendet wird.

2. Verfahren nach Anspruch 1, bei welchem die Pufferschicht (5) basierend auf mindestens einer Verbindung, gewählt aus den Natriumthioindat-Verbindungen NaIn₃S₅, NaIn₅S₈ und NaInS₂, hergestellt wird.

3. Verfahren nach Anspruch 1 oder 2, bei welchem die Pufferschicht (5) in Schritt b) durch nasschemische Badabscheidung, Atomlagenabscheidung (ALD), lonenschichtgasabscheidung (ILGAR), Sprühpyrolyse, chemische Dampfabscheidung (CVD) oder physikalische Dampfabscheidung (PVD), Sputtern, thermisches Verdampfen oder Elektronenstrahlverdampfen, insbesondere aus separaten Quellen für mindestens eine oder verschiedene Natriumthioindat-Verbindungen, hergestellt wird.

4. Verfahren nach einem der Ansprüche 1 bis 3, bei welchem die Pufferschicht (5) in Schritt b) aus der Gasphase abgeschieden wird, wobei die Konzentration von mindestens einer Komponente des abzuscheidenden Materials in deren Gasphase und somit vor deren Abscheidung auf der Absorberschicht (4) verringert wird.

5. Verfahren nach Anspruch 4, bei welchem die Konzentration der mindestens einen Komponente des abzuscheidenden Materials in deren Gasphase durch Bindung an ein in eine Abscheidekammer eingebrachtes Material, an das die Komponente physikalisch und/oder chemisch binden kann, verringert wird.

6. Verfahren nach einem der Ansprüche 1 bis 5, bei welchem die Absorberschicht (4) in einem In-Reihe-Verfahren oder in einem Rotations-Verfahren an einer Dampfkeule einer Natriumthioindat-Verbindung oder an mehreren Dampfkeulen (11, 12) voneinander verschiedener Natriumthioindat-Verbindungen mit vollständig, teilweise oder nicht überlappenden Dampfkeulen vorbeigeführt wird.

7. Verfahren nach einem der Ansprüche 1 bis 6, bei welchem die auf der Absorberschicht (4) angeordnete Pufferschicht (5) Natriumindiumsulfid gemäß der Formel NaₓIn_{y-x/3}S mit 0,063 ≤ x ≤ 0,469 und 0,681 ≤ y ≤ 1,01 enthält.

8. Verfahren nach einem der Ansprüche 1 bis 7, bei welchem die auf der Absorberschicht (4) angeordnete Pufferschicht (5) Natriumindiumsulfid gemäß der Formel NaₓIn_{y-x/3}S mit 0,13 ≤ x ≤ 0,32 und 0,681 ≤ y ≤ 0,78 enthält.

9. Verfahren nach einem der Ansprüche 1 bis 8, bei welchem in der Pufferschicht (5) das Verhältnis der Stoffmengenanteile von Natrium und Indium größer als 0,2 ist.

10. Verfahren nach einem der Ansprüche 1 bis 9, bei welchem die Pufferschicht (5) einen Stoffmengenanteil an Natrium von mehr als 5 Atom-%, insbesondere mehr als 7 Atom-%, insbesondere mehr als 7, 2 Atom-%, aufweist.

11. Verfahren nach einem der Ansprüche 1 bis 10, bei welchem die Pufferschicht (5) einen Stoffmengenanteil an einem Halogen, beispielsweise Chlor, oder an Kupfer von weniger als 7 Atom-%, insbesondere weniger als 5 Atom-%, enthält.

12. Verfahren nach einem der Ansprüche 1 bis 11, bei welchem die Pufferschicht (5) einen Stoffmengenanteil an Sauerstoff von weniger als 10 Atom-% enthält.

13. Verfahren nach einem der Ansprüche 1 bis 12, bei welchem die Pufferschicht (5) eine Schichtdicke von 10 nm bis 100 nm, insbesondere von 20 nm bis 60 nm aufweist, wobei die Pufferschicht (5) amorph oder feinkristallin ist.

14. Verfahren nach einem der Ansprüche 1 bis 13, bei welchem der Chalkopyritverbindungshalbleiter gewählt wird aus Cu₂ZnSn(S,Se)₄, Cu(In,Ga,Al)(S,Se)₂, CulnSe₂, CuInS₂, Cu(In,Ga)Se₂ und Cu(In,Ga)(S,Se)₂.

15. Verfahren zur Herstellung einer Dünnschichtsolarzelle (100), welches umfasst:
- Bereitstellen eines Substrats (2),
- Anordnen einer Rückelektrode (3) auf dem Substrat (2),
- Herstellen eines Schichtsystems (1) nach einem der Ansprüche 1 bis 14, wobei das Schichtsystem (1) auf der Rückelektrode (3) angeordnet wird, und
- Anordnen einer Frontelektrode (7) auf dem Schichtsystem (1).

## Revendications

1. Procédé de production d'un système de couches (1) pour cellules solaires à film mince (100), où
a) une couche absorbante (4) est produite, où la couche absorbante (4) contient un semi-conducteur composé de chalcopyrite, et
b) une couche tampon (5) est produite sur la couche absorbante (4), où la couche tampon (5) contient du sulfure d'indium de sodium selon la formule NaₓIn_{y-x/3}S où 0,063 ≤ X ≤ 0,625 et 0,681 ≤ y ≤ 1,50, où la fraction de pourcentage atomique de sulfure d'indium de sodium dans la couche tampon est d'au moins 75%, et où la couche tampon (5) est produite sans dépôt de sulfure d'indium avec au moins un composé ternaire de thioindate de sodium utilisé comme matériel de base source pour la production de ladite couche tampon.

2. Méthode selon la revendication 1, où la couche tampon (5) est produite sur la base d'au moins un composé, choisi parmi les composés thioindate de sodium NaIn₃S₅, NaIn₅S₈ et NaInS₂.

3. Méthode selon la revendication 1 ou 2, où la couche tampon (5) est produite à l'étape b) par un dépôt humide par bain chimique, un dépôt de couche atomique (ALD), un dépôt gazeux par couche ionique (ILGAR), une pyrolyse par pulvérisation, un dépôt chimique en phase gazeuse (CVD) ou un dépôt physique en phase vapeur (PVD), par pulvérisation, par évaporation thermique ou par évaporation par faisceaux d'électrons, en particulier de sources séparées pour au moins un ou plusieurs composés de thioindate de sodium.

4. Méthode selon l'une des revendications I à 3, où la couche tampon (5) à l'étape b) est déposée hors de la phase gazeuse, où la concentration d'au moins un composant de la matière à déposer est réduite dans sa phase gazeuse et, par conséquent, avant son dépôt sur la couche absorbante (4).

5. Méthode selon la revendication 4, où la concentration de ladite au moins un composant du matériau à déposer est réduite en sa phase gazeuse en étant lié à un matériel introduit dans une chambre de dépôt, à laquelle le composant peut se lier physiquement et/ou chimiquement.

6. Méthode selon l'une des revendications 1 à 5, où la couche absorbante (4) est transportée, dans une méthode en ligne ou dans une méthode de rotation, par un faisceau de vapeur d'un composé de thioindate de sodium ou par une pluralité de faisceaux de vapeur (11, 12) de composés de thioindate de sodium différents les uns des autres avec des faisceaux de vapeur se chevauchant complètement, partiellement ou pas du tout.

7. Méthode selon l'une des revendications 1 à 6, où la couche tampon (5) disposée sur la couche absorbante (4) contient du sulfure d'indium de sodium selon la formule NaₓIn_{y-x/3}S où 0,063 ≤ x ≤ 0,469 et 0,681 ≤ y ≤ 1,01.

8. Méthode selon l'une des revendications 1 à 6, où la couche tampon (5) disposée sur la couche absorbante (4) contient du sulfure d'indium de sodium selon la formule NaₓIn_{y-x/3}S où 0,13 ≤ x ≤ 0,32 et 0,681 ≤ y ≤ 0,78.

9. Méthode selon l'une des revendications 1 à 8, où dans la couche tampon (5), le ratio des fractions molaires du sodium et de l'indium est supérieur à 0,2.

10. Méthode selon l'une des revendications 1 à 9, où la couche tampon (5) a une fraction molaire de sodium supérieure à 5% at., en particulier supérieure à 7% at., en en particulier supérieure à 7,2 % at.

11. Méthode selon l'une des revendications 1 à 10,
où la couche tampon (5) contient une fraction molaire d'un halogène, par exemple, du chlore ou du cuivre inférieure à 7 % at., en particulier inférieure à 5% at.

12. Méthode selon l'une des revendications 1 à 11,
où la couche tampon (5) contient une fraction molaire d'oxygène inférieure à 10% at.

13. Méthode selon l'une des revendications 1 à 12, où la couche tampon (5) présente une épaisseur de couche de 10 nm à 100 nm, en particulier de 20 nm à 60 nm, où la couche tampon (5) est amorphe ou cristalline fine.

14. Méthode selon l'une des revendications 1 à 13, où le semi-conducteur composé de chalcopyrite est sélectionné parmi Cu₂ZnSn(S,Se)₄, Cu(In,Ga,A1)(S,Se)₂, CuInSe₂,CuInS₂, Cu(In,Ga)Se₂, and Cu(In,Ga)(S,Se)₂.

15. Méthode de production d'une cellule solaire à film mince (100), qui comprend:
- la préparation d'un substrat (2),
- l'agencement d'une électrode arrière (3) sur le substrat (2),
- la production d'un système de couches (1) selon l'une des revendications 1 à 14, où le système de couche (1) est disposé sur l'électrode arrière (3), et
- l'agencement d'une électrode avant (7) sur le système de couches (1).
